# EUROPÄISCHE PATENTANMELDUNG

(11) **EP 0 671 647 A1**
(43) Veröffentlichungstag der Anmeldung: **13.09.1995**
(21) Anmeldenummer: 95102937.0
(22) Anmeldetag: 02.03.1995
(51) Int. Cl.: G02F 1/13, G09F 9/35

(54) **Flüssigkristall-Anzeigemodul**

(30) Priorität: 09.03.1994 CH 692/94
(71) Anmelder: SQ Services AG, CH-6312 Steinhausen (CH)
(72) Erfinder: Dornier, Claudio, CH-6312 Steinhausen (CH); Kaufmann, Herbert, CH-6330 Cham (CH); Doggwiler, Heinz, CH-6314 Unterägeri (CH)
(74) Vertreter: Patentanwälte Schaad, Balass & Partner AG

(57) **Zusammenfassung**

Es wird ein Flüssigkristall-Anzeigemodul mit einem Flüssigkristall-Anzeigeelement (10) beschrieben, das über einem eine gedruckte Schaltung (24) aufweisenden, plattenförmigen Träger (20, 20') angeordnet ist. Gummielelastisch ausgebildeten Vielfachleiterelementen (40) verbinden einander zugekehrte elektrische Kontaktflächen-Reihen am Träger und am Anzeigelement untereinander elektrisch. Ferner sind Verbindungsmittel vorgesehen, um Träger und Anzeigeelement mechanisch zusammenzuhalten. Die Grundriss-Abmessungen des Trägers sind nicht grösser als jene des in Deckung mit diesem angeordneten Anzeigeelementes und als Verbindungsmittel ist ausschliesslich eine klebende Substanz (12) vorgesehen.

## Beschreibung

Die Erfindung betrifft ein Flüssigkristall-Anzeigemodul nach dem Oberbegriff des Anspruches 1.

Es sind schon Flüssigkristall-Anzeigemodule der angegebenen Art aus Prospekten der Optrex Corporation, veröffentlicht im Februar 1993, bekanntgeworden. Bei dieser Bauart der Anzeigemodule ist auf der einen Seite des plattenförmigen Trägers das Anzeigeelement angebracht. Als Verbindungsmittel dienen Haltewinkel, die das Anzeigeelement übergreifend am Träger fest machen und dieses über die, als sogenannte Zebraleitgummi ausgebildeten Vielfachleiterelemente gegen den Träger spannen. An der anderen Seite des Trägers sind die Schaltungsbauteile angebracht.

Aus der Dicke des Anzeigeelementes und der Bauteile, sowie der Materialstärke der Träger, der Vielfachleiterelemente und der Haltewinkel, ergeben sich für solche Module Gesamtbauhöhen, die offenbar auch im günstigsten Fall 10mm übersteigen. Bei den Grundriss-Abmessungen addiert sich zu den Abmessungen der Grundfläche des Anzeigeelementes die über diese vorstehenden Ränder des Trägers, an welchen die Haltewinkel befestigt sind. Insbesondere dort wo Anzeigemodule für den Einbau in Hand- oder Taschen-Instrumenten in vorgesehen werden, erschweren oder verhindern die zu grossen Abmessungen die Anwendung solcher Module.

Aufgabe der Erfindung ist daher die Schaffung eines kostengünstig herstellbaren Anzeigemodules mit reduzierten allgemeinen Abmessungen, die die Anwendung auch bei kleinen Instrumenten bzw. Geräten zulassen.

Die Lösung der erfindungsgemässen Aufgabe erfolgt mit den Merkmalen des Kennzeichens von Anspruch 1.

Da die Hauptteile des Moduls unmittelbar aufeinander geschichtet sind, lassen sich die Gesamt-Bauhöhe vergrössernde Abstände vermeiden, ohne in diesen Biegespannungen zu erzeugen.

Gemäss einer bevorzugten Ausführungsform der Erfindung sind die Schaltungsbauteile und insbesondere die integrierte Schaltung, nachfolgend IC genannt, auf der dem Anzeigeelement zugekehrten Seite des Trägers angeordnet, wobei eine rahmenförmige Distanzplatte zwischen Anzeigeelement und Träger in ihrem Innenraum IC sowie in der Regel alle übrigen Schaltungsteile umfasst. Vom einfachen Aufbau und der kostengünstigen Montage abgesehen, liegt ein wesentlicher Vorteil dieser Ausführung darin, dass IC und die übigen von der Distanzplatte umfassten Schaltungsteile dank der Verklebung hermetisch abgeschlossen sind.

Nachfolgend wird die Erfindung in zwei Ausführungsbeispielen anhand der Zeichnung näher erläutert. Es zeigen:
- Fig. 1: das Flüssigkristall-Anzeigemodul nach dem ersten Ausführungsbeispiel in Draufsicht, in nicht-masstäblicher Darstellung;
- Fig. 2: das Modul nach Fig. 1 im Schnitt entlang Linie A - A;
- Fig. 3: ein Schnitt entlang Linie B - B in Fig. 2;
- Fig. 4: ein Querschnitt durch das Modul nach dem zweiten Ausführungsbeispiel; und
- Fig. 5: ein Schnitt nach Linie C - C in Fig. 4.

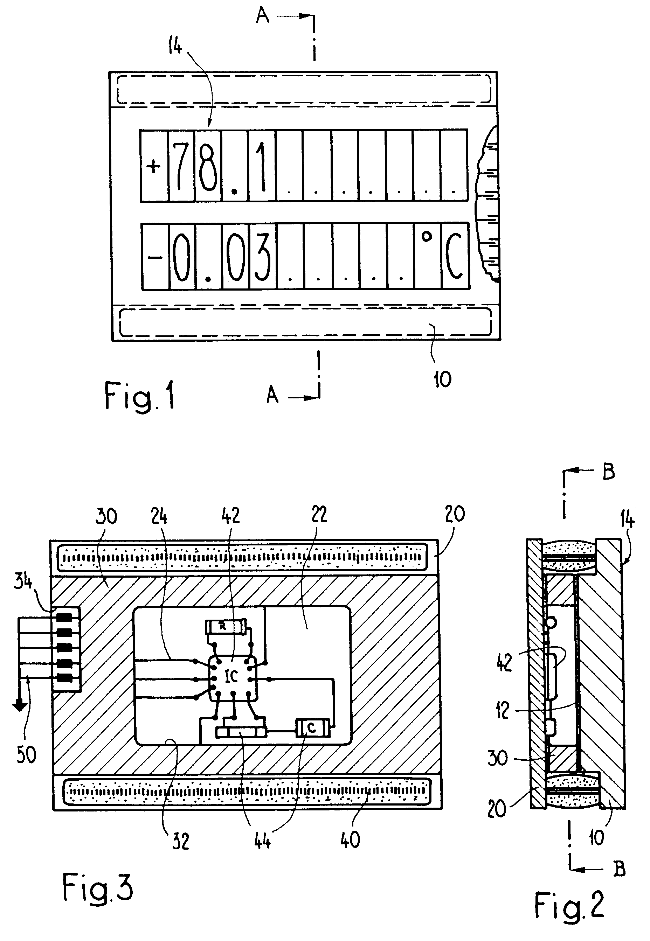

Das Flüssigkristall-Anzeigemodul nach dem Ausführungsbeipiel der Fig. 1 - 3 umfasst drei unmittelbar aufeinanderliegende Hauptteile, nämlich ein Füssigkristall - Anzeigeelement 10, einen plattenförmigen Träger 20 und eine rahmenförmige Distanzplatte 30. Die Letztere ist sandwichartig zwischen den erstern angeordnet und vermittels eines Klebers, z.B 2-Komponenten Epoxy-Kleber, sowohl mit der Rückseite 12 des Anzeigeelementes 10 wie auch mit der Oberseite 22 des Trägers 20 bleibend verbunden. Die rahmenartige Distanzplatte 30 begrenzt eine in deren Dicke durchgehende, vorzugsweise rechteckige Aussparung 32 und besitzt an ihrem Rand einen seitlich offenen Ausschnitt 34.

An der Oberseite 22 des aus einem elektrisch isolierenden Material gefertigten Trägers 20 ist eine nur andeutungsweise dargestellte gedruckte Schaltung 24 aufgebracht, mit welcher ein gehäuseloser IC 42 und beispielhaft angedeutete Schaltungsbauteile 44, wie z.B Widerstände und Kondensatoren, elektrisch leitend verbunden sind. Die Schaltung 24 ist so angeordnet, dass IC 42 und die Schaltungsbauteile 44 als über die Oberseite des Trägers vorstehende Elemente in die Aussparung 32 der Distanzplatte zu liegen kommen. Infolge der Dicke der Platte und der Grösse der Aussparung findet sich für diese SMD-Teile in der Regel ausreichend freier Raum. Im vorliegenden Ausführungsbeispiel ist der Träger 20 aus keramischem Material gefertigt, auf welchem die gedruckte Schaltung im sogenannten Dickschichtpastendruck aufgebracht ist.

Zwischen dem Anzeigeelement 10 und dem Träger 20 sind entlang den Längsrändern des ersteren, jedoch innerhalb seiner Grundrissabmessungen streifenförmig ausgebildete gummielastische Vielfachleiterelemente 40 angeordnet. Dabei handelt es sich um sogennante Zebraleitgummis, die nicht dargestellte Kontaktflächen-Reihen auf den Seiten 22 und 12 verbinden. In der dargestellten Anordnung befinden sich die Zebraleitgummis unter elastischer Vorspannung geeigneter Grösse in Richtung der Kontaktflächen, sodass eine zuverlässige und dauerhafte elektrische Verbindung gewährleistet werden kann.

Der offene Ausschnitt 34 in der Distanzplatte 30 nimmt einen schematisch dargestellten äusseren Stecker 50 auf, welcher die lösbare Verbindung zu der Ansteuerung des Moduls dienenden Kontakten der Schaltung auf dem Träger herstellt. Der Stecker 50 ist Teil eines das Modul aufnehmenden Gerätes (nicht dargestellt).

Wie die Darstellung der Vorderseite 14 des Anzeigeelementes in Fig. 1 erkennen lässt, handelt es sich bei diesem z.B um solches mit zwei Zeichenreihen im Sichtfeld. Jedoch lässt sich der erfindungsgemässe Aufbau unabhängig von der Ausgestaltung des Sichtfeldes anwenden.

Wie ersichtlich hat das Modul als Ganzes die Grundriss-Abmessungen des Anzeigeelementes und dessen Dicke entspricht umittelbar der Summe der Dicken von Anzeigeelement, Träger und Distanzelement. In der Regel lässt sich diese Dicke unter 5 mm halten.

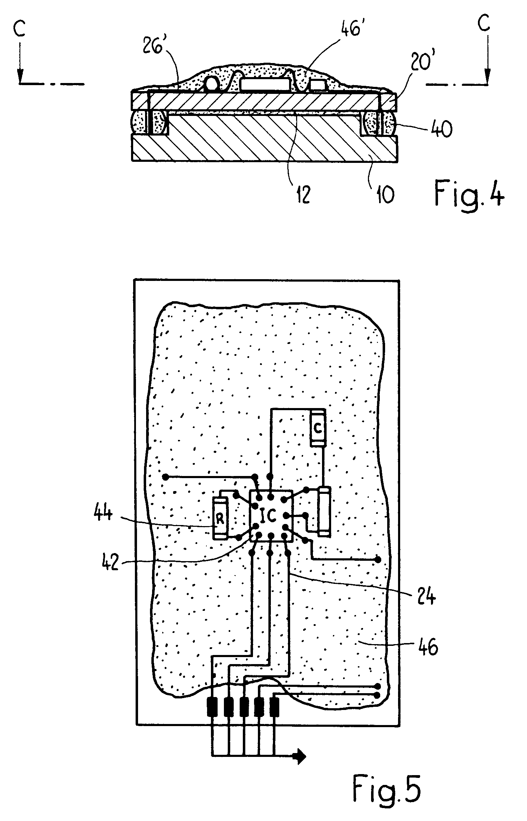

Das Modul nach dem in den Fig. 4 und 5 dargstellten Ausführungsbeispiel unterscheidet sich von jenem nach den Fig. 1 - 3 dadurch, dass der Träger 20' unmittelbar an der Rückseite 12 des Anzeigeelementes 10 vermittels eines Klebers befestigt ist. Der Träger 20' ist auf dessen Rückseite 26' mit der gedruckten Schaltung 24 versehen und dementsprechen sind IC 42 und Schaltungsbauteile 44 ebenfalls auf dieser Seite angebracht. Mit 46 ist eine Vergussmasse bezeichnet, welche die Rückseite 26' bedeckt und die Teile 42 und 44 zumindest gegen Feuchteeinflüsse schützt. Die Verbindung zwischen den Zebraleitgummis 40 und der Schaltung 24 ist über nicht dargestellte elektrische Durchführungen im Träger 20' hergestellt.

Während zwar bei einer Ausführung des Moduls mit dem Anzeigeelement zugekehrten Bauteilen erfindungsgemäss ebenfalls in Betracht kommt, den Zwischenraum zum Träger mit einer die Klebeverbindung herstellenden Vergussmasse, z.B. einem Giessharz auszufüllen, ist die Verwendung einer die Distanzierungsfunktion übernehmenden ausgesparten Platte bzw. eines Rahmens auch kostenmässig vorzuziehen.

## Patentansprüche

1. Flüssigkristall-Anzeigemodul, mit einem Flüssigkristall-Anzeigeelement (10), das über einem eine gedruckte Schaltung (24) aufweisenden, plattenförmigen Träger (20, 20') angeordnet ist, mit gummielelastisch ausgebildeten Vielfachleiterelementen (40), die einander zugekehrte elektrische Kontaktflächen-Reihen am Träger und am Anzeigelement untereinandner elektrisch verbinden, sowie mit Verbindungsmitteln, um Träger und Anzeigeelement mechanisch zusammenzuhalten, dadurch gekennzeichnet, dass die Grundriss-Abmessungen des Trägers nicht grösser als jene des in Deckung mit diesem angeordneten Anzeigeelementes sind und dass als Verbindungsmittel ausschliesslich eine klebende Substanz vorgesehen ist.

2. Anzeigemodul nach Anspruch 1, mit durch Zebraleitgummis gebildeten Vielfachleiterelementen (40), dadurch gekennzeichnet, dass Schaltungsbauteile (42, 44) auf der dem Anzeigeelement zugekehrten Oberseite (22) des Trägers (20) angeordnet sind und der diese Bauteile umgebende Zwischenraum ein Füllmaterial enthält.

3. Anzeigemodul nach Anspruch 2, dadurch gekennzeichnet, dass als Füllmaterial zwischen Anzeigeelement (10) und Träger (20) eine rahmenförmige Distanzplatte (30) mit einer die Bauteile (42, 44) aufnehmenden Aussparung vorgesehen ist.

4. Anzeigemodul nach Anspruch 3, dadurch gekennzeichnet, dass ein Kleber Distanzplatte (30) und Träger (20) sowie Distanzplatte und Anzeigeelement (10) über entsprechend einander zugekehrte Flächen verbindet.

5. Anzeigemodul nach Anspruch 2, dadurch gekennzeichnet, dass das Füllmaterial ein Giessharz ist.

6. Anzeigemodul nach Anspruch 4, dadurch gekennzeichnet, dass das Innere der Aussparung (34) in der Distanzplatte (30) hermetisch abgedichtet ist.

7. Anzeigemodul nach Anspruch 2, dadurch gekennzeichnet, dass entlang einem Breitseitenrand am Träger (20) Ansteuerkontakte auf der Oberseite (22) vorgesehen und durch einen seitlich offenen Ausschnitt (34) in der Distanzplatte (30) von aussen zugänglich sind.
